# EUROPEAN PATENT SPECIFICATION

(11) **EP 3 540 093 B1**
(45) Date of publication and mention of the grant of the patent: **05.01.2022**
(21) Application number: 17876560.8
(22) Date of filing: 24.11.2017
(51) Int. Cl.: B05D 1/00, B05D 3/12, C23C 16/458, C23C 16/50

(54) **PLANETARY ROTARY SHELF DEVICE FOR NANO-COATING APPARATUS**
ROTIERENDE PLANETENREGALVORRICHTUNG FÜR NANOBESCHICHTUNGSVORRICHTUNG
DISPOSITIF À ÉTAGÈRE ROTATIVE PLANÉTAIRE POUR APPAREIL DE NANO-REVÊTEMENT

(30) Priority: 30.11.2016 CN 201611076982
(43) Date of publication of application: 18.09.2019
(73) Proprietor: Jiangsu Favored Nanotechnology Co., Ltd, Wuxi, Jiangsu 214183 (CN)
(72) Inventor: ZONG, Jian, Wuxi, Jiangsu 214183 (CN)
(74) Representative: Berkkam, Ayfer
(86) International application number: PCT/CN2017/112918
(87) International publication number: WO 2018/099332

(56) References cited:
- CN-A- 103 703 163
- CN-A- 104 903 491
- CN-A- 106 637 140
- CN-U- 206 359 611
- US-A1- 2006 049 044
- US-A1- 2006 102 588
- US-A1- 2010 219 160

## Description

### TECHNICAL FIELD

The present invention belongs to the field of vacuum coating technologies, and particularly relates to a planetary rotary rack device for nano coating equipment.

### BACKGROUND

As an effective method for improving surface properties of materials, plasma coating has been widely applied to the aerospace industry, automobile manufacturing, machinery, heavy industry, hardware tool manufacturing and other fields. During the plasma coating, the air in a chamber of the coating equipment needs to be exhausted in order to maintain a low pressure state; and at the same time, process and chemical monomer gases need to be supplied for reacting to generate a polymer coating. Since continuous air exhausting is needed throughout the entire plasma coating process and the locations of the air exhausting port, the air inlet and the feeding port are fixed, the chemical monomer gas tends to diffuse towards the air exhausting port, resulting in a relatively high density of the chemical monomer gas in the areas of the feeding port and the diffusing direction. As such, there is a phenomenon of a thicker polymer coating on the surfaces of coated work pieces in these areas and a thinner coating in other areas, which results in inconsistent quality in batch production. US 2006/049044 A1 discloses a support for mounting a substrate in a coating system, the support comprising a planetary rotating platform suspended above a coating source in a vacuum chamber of a physical vapor deposition system or a chemical vapor deposition system, wherein the substrate holder uses a magnetic latch. US 2010/0219160 A1 discloses a device for treating the surface of a three-dimensional part by using elementary plasma sources by electron cyclotron resonance. The device comprises one linear row of elementary sources plasma and means for subjecting the at least one part to at least one movement of revolution. The combination of revolution movement and with the linear arrangement of elementary forces of plasma produces a uniform treatment of the tree-dimensional surfaces of the complex parts. None of the prior art documents relates to nanocoating.

### TECHNICAL PROBLEM

The objective of the present invention is to overcome the above deficiencies and provide a planetary rotary rack device for nano coating equipment.

### SOLUTION TO THE PROBLEM

### TECHNICAL SOLUTION

The above objective of the present invention is achieved through the following technical solutions: a planetary rotary rack device for nano coating equipment, characterized in that the device includes a chamber, an air exhausting port connected to the top of the chamber, a vacuum pump connected to the air exhausting port, an air inlet valve connected to the chamber via an air inlet pipeline, a feeding valve connected to the chamber via a feeding pipeline, a radio frequency power supply connected to an electrode in the chamber via a wire, and a hollow tube installed at a central axis location of the chamber. A through hole is formed on the hollow tube, the air exhausting port is connected to the upper end of the hollow tube, a rotary motor is installed at the bottom of the chamber, and a planetary rotary rack is installed on the rotary motor.

The planetary rotary rack includes a rotary shaft and a rotary rack, wherein the rotary shaft is connected to the rotary motor; the rotary shaft and the hollow tube are coaxial; the rotary rack is fixed to the rotary shaft; at least two planetary rotary shafts are disposed on the rotary rack, symmetrically; at least one rack layer is disposed on the planetary rotary shafts; the planetary rotary shafts are perpendicular to the rotary rack and are capable of rotating; and the work piece to be processed is placed on the rack layer.

The number of the planetary rotary shafts is 2-8, and the number of the rack layers is 1-10.

The volume of the chamber is 50-3000 L, and the chamber material is aluminum alloy or stainless steel.

The power of the vacuum pump is 3-50 KW, and the pumping speed is 600-1200 m³/h.

The power of the rotary motor is 30-3000 W, and the power of the radio frequency power supply is 50-1500 W.

The present invention has the following advantageous effects.

(1) During coating, a work piece not only revolves around a central rotary shaft, but also rotates around the planetary rotary shaft. The continuous dual rotation prevents uneven densities of the chemical monomer gas in different areas from causing the phenomenon of uneven coating thickness of work pieces in fixed areas. At the same time, the rotary movement of the rotary rack is beneficial for full and even mixing of the chemical monomer gas in the chamber.

(2) The through hole on the hollow tube at the location of the central shaft can make the chemical monomer gas in the chamber develop a trend to diffuse towards the location of the through hole in the radial direction of each rack layer, resulting in a more even density of the chemical monomer gas from the chamber wall to the hollow tube.

### BRIEF DESCRIPTION OF THE DRAWING

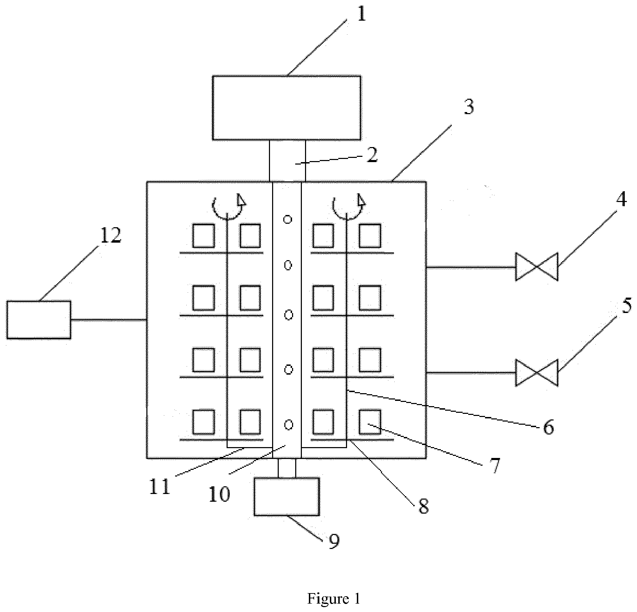

Figure 1 is a structural schematic diagram of a planetary rotary rack device for nano coating equipment.

Wherein, 1. Vacuum Pump; 2. Air Exhausting Port; 3. Chamber; 4. Air Inlet Valve; 5. Feeding Valve; 6. Planetary Rotary Shaft; 7. Work Piece; 8. Rack Layer; 9. Rotary Motor; 10. Hollow Tube; 11. Rotary Rack; 12. Radio Frequency Power Supply.

### DETAILED DESCRIPTION OF THE EMBODIMENT

The present invention will be further described below with reference to the accompanying drawings and specific implementation manners.

### Embodiment 1

As shown in Figure 1, a planetary rotary rack device for nano coating equipment includes a chamber, an air exhausting port 2 connected to the top of the chamber 3, a vacuum pump 1 connected to the air exhausting port, an air inlet valve 4 connected to the chamber 3 via an air inlet pipeline, a feeding valve 5 connected to the chamber 3 via a feeding pipeline, a radio frequency power supply 12 connected to an electrode in the chamber 3 through a wire, and a hollow tube 10 installed at the central axis location of the chamber. Through holes are formed on the hollow tube, the air exhausting port is connected to the upper end of the hollow tube, a rotary motor 9 is installed at the bottom of the chamber, and a planetary rotary rack is installed on the rotary motor.

The planetary rotary rack includes a rotary shaft and a rotary rack 11, wherein the rotary shaft is connected to the rotary motor; the rotary shaft and the hollow tube are coaxial; the rotary rack 11 is fixed to the rotary shaft; the planetary rotary shafts 6 are disposed on the rotary rack, symmetrically; the rack layer 8 is disposed on the planetary rotary shafts; the planetary rotary shafts are perpendicular to the rotary rack and is capable of rotating; and a work piece 7 to be processed is placed on the rack layer.

The number of the planetary rotary shafts is 2, and the number of the rack layer is 1.

The volume of the chamber 3 is 50 L, and the chamber material is aluminum alloy.

The power of the vacuum pump 1 is 3 KW, and the pumping speed is 600 m³/h.

The power of the rotary motor 6 is 30 W, and the power of the radio frequency power supply is 50 W.

The working process of the present invention is shown as follows: first, the work piece 7 to be coated is placed on the rack layer 8 in the chamber 3 of the coating equipment; the air in the chamber 3 is exhausted by the vacuum pump 1 via the air exhausting port, so that the pressure in the chamber 3 can be lowered below 1 Pa; then the process gas is supplied from the air inlet port to the chamber via the air inlet valve 4; and then the chemical monomer gas is added from the feeding port to the chamber via the feeding valve 5. The rotary motor 9 drives the rotary shaft to rotate, and in the meanwhile, make the planetary rotary shaft 6 drive the rotation of the rack layer. The discharging is carried out by the radio frequency power supply 12 so as to initiate the polymerization of the chemical monomer gas and deposition thereof on the surface of the work piece 7 to form the polymer coating.

### Embodiment 2

The structure of each part as well as the connection relationship of a planetary rotary rack device for nano coating equipment in this embodiment are the same as those in Embodiment 1, and the differences in technical parameters are shown as follows.

The number of the planetary rotary shafts is 4, and the number of the rack layers is 3.

The volume of the chamber 3 is 600 L, and the chamber material is aluminum alloy.

The power of the vacuum pump 1 is 10 KW, and the pumping speed is 700 m³/h.

The power of the rotary motor 6 is 400 W, and the power of the radio frequency power supply is 600 W.

### Embodiment 3

The structure of each part as well as the connection relationship of a planetary rotary rack device for nano coating equipment in this embodiment are the same as those in Embodiment 1, and the differences in technical parameters are shown as follows.

The number of the planetary rotary shafts is 4, and the number of the rack layers is 5.

The volume of the chamber 3 is 1200 L, and the chamber material is stainless steel.

The power of the vacuum pump 1 is 20 KW, and the pumping speed is 900 m³/h.

The power of the rotary motor 6 is 800 W, and the power of the radio frequency power supply is 900 W.

### Embodiment 4

The structure of each part as well as the connection relationship of a planetary rotary rack device for nano coating equipment in this embodiment are the same as those in Embodiment 1, the differences in technical parameters are shown as follows.

The number of the planetary rotary shafts is 6, and the number of the rack layers is 8.

The volume of the chamber 3 is 2200 L, and the chamber material is stainless steel.

The power of the vacuum pump 1 is 40 KW, and the pumping speed is 1100m³/h.

The power of the rotary motor 6 is 1800 W, and the power of the radio frequency power supply is 1200 W.

### Embodiment 5

The structure of each part as well as the connection relationship of a planetary rotary rack device for nano coating equipment in this embodiment are the same as those in Embodiment 1, and the differences in technical parameters are shown as follows.

The number of the planetary rotary shafts is 8, and the number of the rack layers is 10.

The volume of the chamber 3 is 3000 L, and the chamber material is stainless steel.

The power of the vacuum pump 1 is 50 KW, and the pumping speed is 1200m³/h.

The power of the rotary motor 6 is 3000 W, and the power of the radio frequency power supply is 1500 W.

## Claims

1. A planetary rotary rack device for nano coating equipment, **characterized in that** the planetary rotary rack device comprises a chamber, an air exhausting port (2) connected to a top of the chamber (3), a vacuum pump (1) connected to the air exhausting port, an air inlet valve (4) connected to the chamber (3) via an air inlet pipeline, a feeding valve (5) connected to the chamber (3) via a feeding pipeline, a radio frequency power supply (12) connected to an electrode in the chamber (3) via a wire, and a hollow tube (10) installed at a central axis location of the chamber; wherein through holes are formed on the hollow tube, the air exhausting port is connected to an upper end of the hollow tube, a rotary motor (9) is installed at a bottom of the chamber, and a planetary rotary rack is installed on the rotary motor;
the planetary rotary rack comprises a rotary shaft and a rotary rack (11), wherein the rotary shaft is connected to the rotary motor; the rotary shaft and the hollow tube are coaxial; the rotary rack (11) is fixed to the rotary shaft; at least two planetary rotary shafts (6) are disposed on the rotary rack, symmetrically; at least one rack layer (8) is disposed on the planetary rotary shafts; the planetary rotary shafts are perpendicular to the rotary rack and are capable of rotating; and a work piece (7) to be processed is placed on the rack layer.

2. The planetary rotary rack device for nano coating equipment according to claim 1, **characterized in that** the number of the planetary rotary shafts is 2 - 8, and the number of the rack layers is 1 - 10.

3. The planetary rotary rack device for nano coating equipment according to claim 1, **characterized in that** a volume of the chamber (3) is 50 - 3000 L, and a chamber material is aluminum alloy or stainless steel.

4. The planetary rotary rack device for nano coating equipment according to claim 1, **characterized in that** the power of the vacuum pump is 3 - 50 KW, and a pumping speed is 600 - 1200 m³/h.

5. The planetary rotary rack device for nano coating equipment according to claim 1, **characterized in that** the power of the rotary motor (6) is 30-3000 W, and the power of the radio frequency power supply is 50-1500 W.

## Patentansprüche

1. Eine planetarische Drehgestellvorrichtung für eine Nanobeschichtungsanlagen, **dadurch gekennzeichnet, dass** die planetarische Drehgestellvorrichtung eine Kammer, eine mit einer Oberseite der Kammer (3) verbundene Luftauslassöffnung (2), eine mit der Luftauslassöffnung verbundene Vakuumpumpe (1), ein über eine Lufteinlassleitung mit der Kammer (3) verbundenes Lufteinlassventil (4), ein über eine Speiseleitung mit der Kammer (3) verbundenes Speiseventil (5), eine über einen Draht mit einer Elektrode in der Kammer (3) verbundene Radiofrequenzstromversorgung (12) und ein an einer Mittelachsenstelle der Kammer installiertes Hohlrohr (10) umfasst; wobei Durchgangslöcher an dem Hohlrohr gebildet sind, die Luftauslassöffnung mit einem oberen Ende des Hohlrohrs verbunden ist, ein Drehmotor (9) am Boden der Kammer installiert ist und eine Planetendrehzahnstange an dem Drehmotor installiert ist;
das planetarische Drehgestell umfasst eine Drehwelle und ein Drehgestell (11), wobei die Drehwelle mit dem Drehmotor verbunden ist; die Drehwelle und das Hohlrohr sind koaxial; das Drehgestell (11) ist an der Drehwelle befestigt; mindestens zwei planetarische Drehwellen (6) sind symmetrisch an der Drehstange angeordnet; mindestens eine Gestellschicht (8) auf den planetarische Drehwellen angeordnet ist; die planetarische Drehwellen stehen senkrecht zum Drehstell und können sich drehen; und ein zu bearbeitendes Werkstück (7) wird auf die Gestellschicht gelegt.

2. Die planetarische Drehgestellvorrichtung für eine Nanobeschichtungsanlage nach Anspruch 1, **dadurch gekennzeichnet, dass** die Anzahl der Planetendrehwellen 2 - 8 beträgt und die Anzahl der Gestellschichten 1 - 10 beträgt.

3. Die planetarische Drehgestellvorrichtung für eine Nanobeschichtungsanlage nach Anspruch 1, **dadurch gekennzeichnet, dass** ein Volumen der Kammer (3) 50 - 3000 L beträgt und das Kammermaterial eine Aluminiumlegierung oder Edelstahl ist.

4. Die planetarische Drehgestellvorrichtung für Nanobeschichtungsanlagen nach Anspruch 1, **dadurch gekennzeichnet, dass** die Leistung der Vakuumpumpe 3 - 50 KW beträgt und eine Sauggeschwindigkeit 600 - 1200 m³/h beträgt.

5. Die planetarische Drehgestellvorrichtung für Nanobeschichtungsanlagen nach Anspruch 1, **dadurch gekennzeichnet, dass** die Leistung des Drehmotors (6) 30-3000 W beträgt und die Leistung der Radiofrequenzstromversorgung 50-1500 W beträgt.

## Revendications

1. Dispositif à crémaillère rotative planétaire pour un équipement de nano revêtement, **caractérisé en ce que** le dispositif à crémaillère rotative planétaire comprend une chambre, un orifice d'évacuation d'air (2) connecté à un sommet de la chambre (3), une pompe à vide (1) connectée à l'orifice d'évacuation d'air, une vanne d'entrée d'air (4) connectée à la chambre (3) via une conduite d'entrée d'air, une vanne d'alimentation (5) connectée à la chambre (3) via une conduite d'alimentation, une alimentation électrique à radiofréquence (12) connectée à une électrode dans la chambre (3) via un fil, et un tube creux (10) installé à un emplacement d'axe central de la chambre ; dans lequel des trous traversants sont formés sur le tube creux, l'orifice d'évacuation d'air est connecté à une extrémité supérieure du tube creux, un moteur rotatif (9) est installé au fond de la chambre, et une crémaillère rotative planétaire est installée sur le moteur rotatif ;
la crémaillère rotative planétaire comprend un arbre rotatif et une crémaillère rotative (11), dans laquelle l'arbre rotatif est connecté au moteur rotatif ; l'arbre rotatif et le tube creux sont coaxiaux ; la crémaillère rotative (11) est fixée à l'arbre rotatif ; au moins deux arbres rotatifs planétaires (6) sont disposés sur la crémaillère rotative, symétriquement ; au moins une couche de crémaillère (8) est disposée sur les arbres rotatifs planétaires ; les arbres rotatifs planétaires sont perpendiculaires à la crémaillère rotative et sont capables de tourner ; et une pièce de travail (7) à traiter est placée sur la couche de crémaillère.

2. Dispositif à crémaillère rotative planétaire pour un équipement de nano revêtement selon la revendication 1, **caractérisé en ce que** le nombre d'arbres rotatifs planétaires est de 2 - 8, et le nombre de couches de crémaillère est de 1 - 10.

3. Dispositif à crémaillère rotative planétaire pour un équipement de nano revêtement selon la revendication 1, **caractérisé en ce qu'**un volume de la chambre (3) est de 50 - 3000 L, et un matériau de la chambre est un alliage d'aluminium ou un acier inoxydable.

4. Dispositif à crémaillère rotative planétaire pour un équipement de nano revêtement selon la revendication 1, **caractérisé en ce que** la puissance de la pompe à vide est de 3 - 50 KW, et la vitesse de pompage est de 600 -1200 m³/h.

5. Dispositif à crémaillère rotative planétaire pour un équipement de nano revêtement selon la revendication 1, **caractérisé en ce que** la puissance du moteur rotatif (6) est de 30-3000 W, et la puissance de l'alimentation en radiofréquence est de 50-1500 W.
